# EUROPÄISCHE PATENTANMELDUNG

(11) **EP 2 317 578 A2**
(43) Veröffentlichungstag der Anmeldung: **04.05.2011**
(21) Anmeldenummer: 10182168.4
(22) Anmeldetag: 29.09.2010
(51) Int. Cl.: H01L 41/04, H01L 41/053, F02M 51/06

(54) **Piezoelektrischer Aktor**

(30) Priorität: 03.11.2009 DE 102009046308
(71) Anmelder: Robert Bosch GmbH, 70442 Stuttgart (DE)
(72) Erfinder: Kiontke, Martin, 71254, Ditzingen (DE); Dirscherl, Florian, 96049, Bamberg (DE)

(57) **Zusammenfassung**

Ein piezoelektrischer Aktor (2), der insbesondere für Brennstoffeinspritzventile (1) dient, weist einen Aktorkörper (14) und zumindest ein Übergangsstück (12) auf. Dabei weist das Übergangsstück (12) eine Aufnahme (30) auf, in die ein Führungselement (27) eingesetzt ist. Ferner ist eine Kabeldurchführung (23) vorgesehen, die einerseits in die Aufnahme (30) mündet. Außerdem ist eine elektrische Leitung (17) vorgesehen, die abschnittsweise durch das Führungselement (27), abschnittsweise durch die Kabeldurchführung (23) und zwischen dem Führungselement (27) und der Kabeldurchführung (23) abschnittsweise durch einen Teil (31) der Aufnahme (30) des Übergangsstücks (12) geführt ist. Hierbei ist der Teil (31) der Aufnahme (30) mit einem Dichtmittel (31') gefüllt, so dass eine zuverlässige Abdichtung gebildet ist. Das Dichtmittel (31') kann beispielsweise aus einem gehärteten Klebstoff oder aus einem aufgeschmolzenen Klebstoff gebildet sein. Hierbei kann eine Medienbeständigkeit gegenüber Wasser, Öl, Diesel oder Fettsäure-Methylester gewährleistet werden.

## Beschreibung

### Stand der Technik

Die Erfindung betrifft einen piezoelektrischen Aktor für ein Brennstoffeinspritzventil und ein Brennstoffeinspritzventil mit einem piezoelektrischen Aktor. Speziell betrifft die Erfindung das Gebiet von Injektoren für Brennstoffeinspritzanlagen von luftverdichtenden, selbstzündenden Brennkraftmaschinen.

Aus der DE 103 36 327 A1 ist ein Injektor für Einspritzsysteme von Brennkraftmaschinen, insbesondere von direkteinspritzenden Dieselmotoren bekannt. Bei dem bekannten Injektor ist ein in einem Injektorkörper angeordneter Piezoaktor vorgesehen, der durch eine Druckfeder mit dem Injektor und andererseits mit einem hülsenartigen Übersetzerkolben in Anlage gehalten wird. Durch den von der Druckfeder über den Übersetzerkolben auf den Piezoaktor wirkenden Druck wird der Piezoaktor dabei an seiner Oberseite gegen den Injektorkörper abgedichtet. Dadurch kann ein elektrischer Anschluss durch eine abgewinkelte Bohrung aus dem Injektorkörper herausgeführt werden.

Der aus der DE 103 36 327 A1 bekannte Injektor hat den Nachteil, dass über die abgewinkelte Bohrung ein Medium zu den elektrischen Anschlüssen des Piezoaktors gelangen kann. Unter anderem kann Wasser in die abgewinkelte Bohrung eindringen. Hierbei besteht das Problem, dass der elektrische Anschluss auf geeignete Weise zu dem Piezoaktor geführt werden muss. Das in die Bohrung eingedrungene Wasser kann dann weiter zu dem Piezoaktor vordringen oder im Bereich des elektrischen Anschlusses einen Kurzschluss verursachen. Dadurch kann es zum Ausfall des Injektors kommen.

### Offenbarung der Erfindung

Der erfindungsgemäße piezoelektrische Aktor mit den Merkmalen des Anspruchs 1 und das erfindungsgemäße Brennstoffeinspritzventil mit den Merkmalen des Anspruchs 10 haben demgegenüber den Vorteil, dass eine elektrische Anbindung verbessert ist. Speziell besteht der Vorteil, dass ein Eindringen von Wasser oder anderen Medien in den piezoelektrischen Aktor oder das Auftreten eines Kurzschlusses im Bereich der elektrischen Leitungen verhindert ist.

Durch die in den Unteransprüchen aufgeführten Maßnahmen sind vorteilhafte Weiterbildungen des im Anspruch 1 angegebenen piezoelektrischen Aktors und des im Anspruch 10 angegebenen Brennstoffeinspritzventils möglich.

Vorteilhaft ist es, dass der Teil der Aufnahme, durch den die elektrische Leitung zwischen dem Führungselement und der Kabeldurchführung des Übergangsstück geführt ist, durch das Übergangsstück und das in die Aufnahme des Übergangsstücks eingesetzte Führungselement umschlossen ist. Hierdurch ist der Teil der Aufnahme durch das in die Aufnahme des Übergangsstücks eingesetzte Führungselement und das Übergangsstück begrenzt, wobei der dadurch ausgebildete Raum vorzugsweise vollständig mit dem Dichtmittel gefüllt ist. Hierbei kann beispielsweise vor dem Einfügen des Führungselements in die Aufnahme des Übergangsstücks das Dichtmittel in die Aufnahme eingefüllt werden. Im montierten Zustand, in dem das Führungselement in dem Übergangsstück angeordnet ist, kann dann ein Aushärten des Dichtmittels oder dergleichen erfolgen.

Vorteilhaft ist es, dass das Dichtmittel aus der Basis zumindest eines Klebstoffs gebildet ist oder dass das Dichtmittel auf der Basis zumindest eines Silikons gebildet ist. Möglich ist es auch, dass das Dichtmittel in vorteilhafter Weise auf der Basis zumindest eines Fetts, insbesondere eines Anti-Kapillar-Fetts, gebildet ist. Speziell kann das Dichtmittel als ausgehärtete Dichtmasse ausgebildet sein. Ferner ist es vorteilhaft, dass das Dichtmittel aus zumindest einem Klebstoffband ausgebildet ist und/oder dass das Dichtmittel aus zumindest einem aufgeschmolzenen Klebstoff gebildet ist. Dies ermöglicht eine Alternative zu einem viskosen Klebstoff. Dadurch kann die Dichtmasse je nach Anwendungsfall den Anforderungen angepasst werden. Beispielsweise kann eine hohe Temperaturbeständigkeit und/oder ein hohes Dehnungsvermögen zum Ausgleich von Temperaturdehnungen gewährleistet werden. Ferner kann eine hohe Schwingungsfestigkeit des Dichtmittels, insbesondere der ausgehärteten Dichtmasse, erzielt werden. Ferner kann ein hohes Dicht- oder Klebevermögen, insbesondere in Verbindung mit dem Werkstoff des Führungselements oder des Werkstoffs des Übergangsstücks oder einer an der elektrischen Leitung vorgesehenen Isolierung erzielt werden. Außerdem kann eine Medienbeständigkeit gegenüber Wasser, Waschmittel, was bei einer Motorwäsche oder dergleichen eindringen kann, Salz und Motoröl erzielt werden. Somit können die im jeweiligen Anwendungsfall bestehenden Anforderungen durch eine geeignete Wahl des Dichtmittels erfüllt werden.

In vorteilhafter Weise ist zumindest eine weitere elektrische Leitung vorgesehen, die abschnittsweise durch das Führungselement und abschnittsweise durch eine weitere Kabeldurchführung des Übergangsstücks geführt ist, wobei die weitere elektrische Leitung zwischen dem Führungselement und der weiteren Kabeldurchführung neben der elektrischen Leitung durch den mit dem Dichtmittel gefüllten Teil der Aufnahme des Übergangsstücks geführt ist. Hierdurch kann durch das Dichtmittel, das in dem Teil der Aufnahme des Übergangsstücks vorgesehen ist, sowohl eine Abdichtung in Bezug auf die elektrische Leitung als auch auf die weitere elektrische Leitung gewährleistet werden.

In vorteilhafter Weise ist das Übergangsstück an den Aktorkörper gefügt, wobei die Kabeldurchführung andererseits in einen Innenraum einer Dichthülse mündet, wobei in dem Innenraum der Dichthülse der Aktorkörper mit zumindest einer Außenelektrode angeordnet ist und wobei die elektrische Leitung mit der Außenelektrode elektrisch verbunden ist. Über das in dem Teil der Aufnahme des Übergangsstücks vorgesehene Dichtmittel kann hierbei in zuverlässiger Weise eine Abdichtung des Innenraums der Dichthülse erzielt werden. Hierdurch wird ein elektrischer Kurzschluss im Bereich der Außenelektrode oder eine beispielsweise chemische Beschädigung eines Materials des Aktorkörpers verhindert.

Ferner kann das Dichtmittel in vorteilhafter Weise medienbeständig ausgestaltet sein, wobei insbesondere eine Beständigkeit gegenüber Wasser und/oder Öl und/oder Diesel und/oder Fettsäure-Methylester besteht. Speziell kann eine Medienbeständigkeit bezüglich Raps-Methylester oder anderen Fettsäure-Methylestern gewährleistet werden.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer auszugsweisen, schematischen Schnittdarstellung entsprechend einem Ausführungsbeispiel der Erfindung und
Fig. 2 einen auszugsweisen, schematischen Schnitt durch den in der Fig. 1 dargestellten piezoelektrischen Aktors des Brennstoffeinspritzventils des Ausführungsbeispiels entlang der mit II bezeichneten Schnittlinie.

### Ausführungsformen der Erfindung

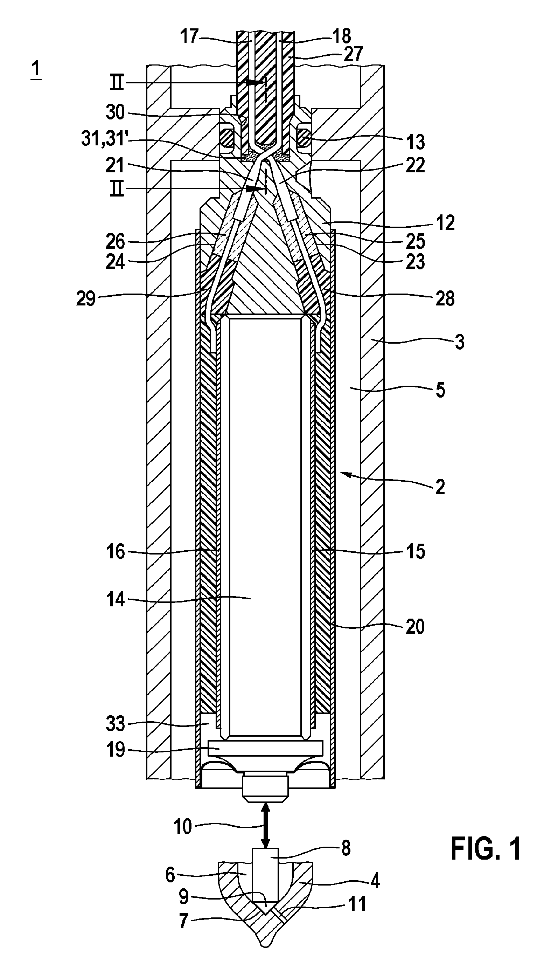

Fig. 1 zeigt ein Brennstoffeinspritzventil 1 mit einem piezoelektrischen Aktor 2 in einer auszugsweisen, schematischen Schnittdarstellung entsprechend einem Ausführungsbeispiel. Der piezoelektrische Aktor 2 ist als Aktormodul 2 beziehungsweise Piezoaktormodul 2 ausgestaltet. Das Brennstoffeinspritzventil 1 kann insbesondere Injektor für Brennstoffeinspritzanlagen von luftverdichtenden, selbstzündenden Brennkraftmaschinen dienen. Ferner eignet sich das Brennstoffeinspritzventil 1 auch für gemischverdichtende, fremdgezündete Brennkraftmaschinen. Ein bevorzugter Einsatz des Brennstoffeinspritzventils 1 besteht für eine Brennstoffeinspritzanlage mit einem Common-Rail, das Brennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 umfasst ein Ventilgehäuse 3. Ferner ist ein Düsenkörper 4 vorgesehen, der auf geeignete Weise, beispielsweise über eine Düsenspannmutter, mit dem Ventilgehäuse 3 verbunden ist. Innerhalb des Ventilgehäuses 3 ist ein Aktorraum 5 ausgebildet, in dem der piezoelektrische Aktor 2 angeordnet ist. Je nach Ausgestaltung des Brennstoffeinspritzventils 1 kann im Betrieb Brennstoff durch den Aktorraum 5 zu einem Brennstoffraum 6, der im Düsenkörper 4 ausgebildet ist, fließen.

Der Düsenkörper 4 weist eine Ventilsitzfläche 7 auf, die mit einem einstückig mit einer Ventilnadel 8 ausgebildeten Ventilschließkörper 9 zu einem Dichtsitz zusammenwirkt. Der piezoelektrische Aktor 2 dient hierbei zur Betätigung der Ventilnadel 8, wie es durch den Doppelpfeil 10 veranschaulicht ist. Beim Betätigen der Ventilnadel 8 hebt sich der Ventilschließkörper 8 von der Ventilsitzfläche 7 ab, so dass der zwischen dem Ventilschließkörper 9 und der Ventilsitzfläche 7 gebildete Dichtsitz geöffnet wird und Brennstoff aus dem Brennstoffraum 6 über eine Düsenöffnung 11 in den Brennraum einer Brennkraftmaschine eingespritzt wird.

Der piezoelektrische Aktor 2 umfasst einen metallischen Aktorfuß 12, an dem der piezoelektrische Aktor 2 in das Ventilgehäuse 3 eingesetzt ist. Zwischen dem Aktorfuß 12 und dem Ventilgehäuse 3 ist hierbei ein Dichtring 13 angeordnet.

Der piezoelektrische Aktor 2 umfasst einen Aktorkörper 14. Der Aktorkörper 14 umfasst eine Vielzahl von keramischen Schichten und eine Vielzahl von zwischen den keramischen Schichten angeordneten Elektrodenschichten. Hierbei sind an einer Außenseite 14' des Aktorkörpers 14 Außenelektroden 15, 16 angebracht. Die einzelnen Elektrodenschichten des Aktorkörpers 14 sind abwechselnd mit den Außenelektroden 15, 16 kontaktiert. Die Außenelektroden 15, 16 sind mit elektrischen Leitungen 15, 18 verbunden. Somit kann über die elektrischen Leitungen 17, 18 ein Laden und Entladen des Aktorkörpers 14 erfolgen. Bei einem Laden des Aktorkörpers 14 dehnt sich dieser aus. Beim Entladen des Aktorkörpers 14 zieht sich dieser wieder zusammen. Beispielsweise kann in einem Ausgangszustand der Aktorkörper 14 geladen sein, um die Düsenöffnung 11 zu verschließen. Durch kurzzeitiges Entladen des Aktorkörpers 14 kann dann ein Hub der Ventilnadel 8 und somit ein Öffnen der Düsenöffnung 11 erreicht werden.

Der Aktorkörper 14 ist zwischen dem Aktorfuß 12 und einem Aktorkopf 19 angeordnet. Hierbei ist der Aktorfuß 12 an einer Seite an den Aktorkörper 14 angefügt, während der Aktorkopf 19 an einer anderen Seite an den Aktorkörper 14 angefügt ist. Außerdem ist eine Dichthülse 20 vorgesehen, die einerseits mit dem Aktorfuß 12 und andererseits mit dem Aktorkopf 19 verbunden ist. Durch die Dichthülse 20 ist ein innerhalb der Dichthülse 20 ausgebildeter Innenraum 33 gegenüber der Umgebung und somit in diesem Ausführungsbeispiel dem Aktorraum abgedichtet. Somit ist der Innenraum 33 beispielsweise gegenüber dem im Aktorraum 5 vorgesehenen Brennstoff abgedichtet. In dem Innenraum 33 sind der Aktorkörper 14 und die an den Aktorkörper 14 angefügten Außenelektroden 15, 16 angeordnet.

Die elektrischen Leitungen 17, 18 können jeweils aus einem Kupferdraht gebildet sein. Hierbei können die elektrischen Leitungen 17, 18 noch abschnittsweise mit Isolierungen 21, 22 ummantelt sein. Beispielsweise können die Isolierungen 21, 22 als Kunststoffummantelungen ausgestaltet sein.

Der Aktorfuß weist im Wesentlichen konisch ausgestaltete Durchgangsbohrungen 23, 24 auf, in die Dichtbuchsen 25, 26 eingesetzt sind. Durch die beispielsweise aus Gummi oder Kunststoff gebildeten Dichtbuchsen 25, 26 ist eine gewisse Abdichtung der Durchgangsbohrungen 23, 24 gewährleistet. Durch Einspritzen von Kunststoff 28, 29 in die Durchgangsbohrungen 23, 24 sind die Dichtbuchsen 25, 26 in den Durchgangsbohrungen 23, 24 arretiert. Hierbei kann auch ein gewisses Verpressen der Dichtbuchsen 25, 26 erfolgen, so dass diese entsprechend einem O-Ring eine zuverlässige Abdichtung gewährleisten.

Im Betrieb des Brennstoffeinspritzventils 1 kann es auf Grund von Temperaturdehnungen und dergleichen zu plastischen Verformungen der Isolierungen 21, 22 und somit zu einer Spaltbildung zwischen den Dichtbuchsen 25, 26 und der jeweiligen Isolierung 21, 22 kommen. Durch solche Temperaturdehnungen kann gegebenenfalls auch eine an einer anderen Stelle vorgesehene Dichtung undicht werden oder in ihrer Dichtwirkung nachlassen. Dadurch kommt es zu dem Problem, dass durch solche Spalte oder nicht mehr dichte beziehungsweise nicht mehr ausreichend dichte Dichtstellen Wasser oder andere Medien dringen können. Hierdurch kann es entweder im Bereich der elektrischen Leitungen 17, 18 zu einem Kurzschluss kommen oder es können Medien über den Weg der elektrischen Leitungen 17, 18 in den Innenraum 33 eindringen. Über die Lebensdauer des Brennstoffeinspritzventils 1 kann es dadurch zu einer Ansammlung von Wasser, die einen Kurzschluss auslöst, oder zum Eindringen von anderen Medien, die beispielsweise das Material des Aktorkörpers 14 schädigen, kommen. Daher ist ein Eindringen von Wasser oder anderen Medien über die Lebensdauer des Brennstoffeinspritzventils 1 zu verhindern.

Der piezoelektrische Aktor 2 weist ein Übergangsstück 12 auf, das in diesem Ausführungsbeispiel durch den Aktorfuß 12 gebildet ist. Der Aktorfuß 12 weist eine Aufnahme 30 auf, in die ein Führungselement 27 eingesetzt ist. In diesem Ausführungsbeispiels befindet sich ein Teil des Führungselements 27 außerhalb der Aufnahme 30, so dass das Führungselement 27 teilweise in die Aufnahme 30 eingesetzt ist. Die elektrischen Leitungen 17, 18 sind abschnittsweise durch das Führungselement 27 geführt. Hierbei lässt das Führungselement 27 einen Teil 31 der Aufnahme 30 frei. Die elektrischen Leitungen 17, 18 sind abschnittsweise durch den Teil 31 geführt. Ferner sind durch die Durchgangsbohrungen 23, 24 Kabeldurchführungen für die elektrischen Leitungen 17, 18 in dem Aktorfuß 12 ausgebildet. Diese Kabeldurchführungen 23, 24 münden einerseits in den Teil 31. Andererseits münden die Kabeldurchführungen 23, 24 in den Innenraum 33.

Somit sind die elektrischen Leitungen 17, 18 abschnittsweise durch das Führungselement 27, zwischen dem Führungselement 27 und den Kabeldurchführungen 23, 24 abschnittsweise durch den Teil 31 der Aufnahme 30 und außerdem jeweils getrennt durch die Kabeldurchführungen 23, 24 in den Innenraum 33 geführt. Im Innenraum 33 sind die elektrischen Leitungen 17, 18 mit den Außenelektroden 15, 16 elektrisch verbunden.

Um eine zuverlässige Abdichtung im Bereich der elektrischen Leitungen 17, 18 zu gewährleisten, ist der Teil 31 der Aufnahme 30 vollständig mit einem Dichtmittel 31' gefüllt. Dieses Dichtmittel 31' gewährleistet auch bei thermischen Einflüssen, Erschütterungen und gegebenenfalls auftretenden Alterungsprozessen eine zuverlässige Abdichtung. Dadurch wird verhindert, dass Wasser oder andere Medien entlang der elektrischen Leitungen 17, 18 in den Innenraum 33 vordringen. Diese Abdichtung ist hierbei durch die Dichtbuchsen 25, 26 unterstützt. Dadurch ist eine zuverlässige Abdichtung geschaffen. Speziell kann im Bereich des Aktorfußes 12 anstehende Feuchtigkeit aus Wasser oder anderen Medien zu keinem Kurzschluss und somit zu keinem Ausfall des Brennstoffeinspritzventils 1 führen.

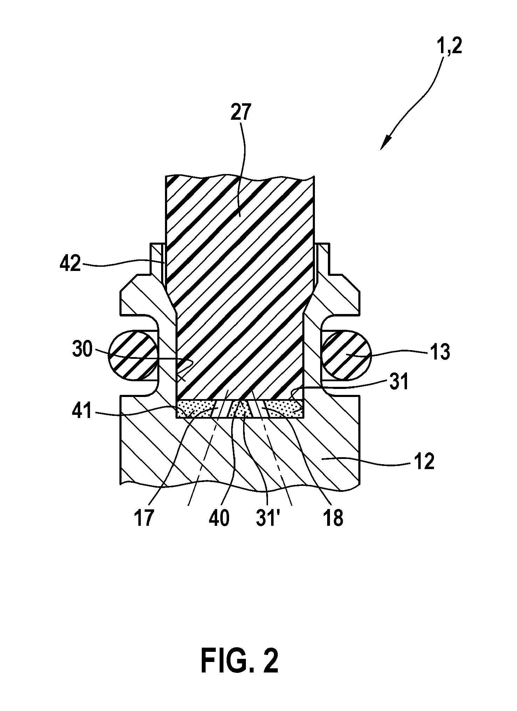

Fig. 2 zeigt den in Fig. 1 dargestellten piezoelektrischen Aktors 2 des Brennstoffeinspritzventils 1 des Ausführungsbeispiels in einer auszugsweisen Schnittdarstellung entlang der mit 11 bezeichneten Schnittlinie. Hierbei wird die Ausgestaltung der Abdichtung durch das Dichtmittel 31' weiter veranschaulicht.

Die elektrischen Leitungen 17, 18 sind nebeneinander durch den Teil 31 der Aufnahme 30 geführt. Hierbei ist der Teil 31 durch eine Unterseite 40 des Führungselements 27 sowie durch die Aufnahme 30, insbesondere eine Stirnseite 41, des Aktorfußes 12 begrenzt. Vor dem Einfügen des Führungselements 27 in die Aufnahme 30 wird das Dichtmittel 31' in die Aufnahme 30 eingefüllt. Nach dem Einpressen des Führungselements 27 in die Aufnahme 30 des Aktorfußes 12 ist der verbleibende Teil 31 der Aufnahme 30 vollständig von dem Dichtmittel 31' gefüllt.

Beim Fügeprozess kann gegebenenfalls auch ein Teil des Dichtmittels 31' aus dem Teil 31 herausgepresst werden, beispielsweise in einen Spalt 42 zwischen dem Aktorfuß 12 und dem Führungselement 27 oder in die Durchgangsbohrungen 23, 24, die als Kabeldurchführungen 23, 24 dienen.

Somit sind die Kabeldurchführungen 23, 24 zuverlässig gegenüber der Umgebung abgedichtet. Speziell ist eine Abdichtung gegenüber von der Seite des Führungselements 27 eindringende Nässe oder andere Medien gewährleistet. Wasser oder andere Medien können dadurch nicht in die Kabeldurchführungen 23, 24 gelangen.

Das Dichtmittel 31' kann auf der Basis zumindest eines Klebstoffs gebildet sein. Speziell kann ein viskoser Klebstoff zum Einsatz kommen. Solch ein viskoser Klebstoff kann durch ein geeignetes Härtungsverfahren ausgehärtet werden. Durch eine angepasste Prozessführung wird sichergestellt, dass der Teil 31 einschließlich eventuell vorhandener Unstetigkeiten, insbesondere Riefen, blasenfrei verfüllt wird. Die Aushärtung erfolgt in Abhängigkeit des verwendeten Klebstoffs durch Wärme, Luftabschluss, UV-Strahlung oder einen anderen Mechanismus.

Ferner kann in Bezug auf die Fügepartner, insbesondere das Material des Führungselements 27 und das Material des Aktorfußes 12 sowie der elektrischen Leitungen 17, 18 beziehungsweise der Isolierungen 21, 22, eine Oberflächenbehandlung oder Oberflächenaktivierung durchgeführt werden. Dadurch kann die Haftung des Dichtmittels 31 an den Fügepartnern, insbesondere dem Führungselement 27, dem Aktorfuß 12, den elektrischen Leitungen 17, 18 beziehungsweise den Isolierungen 21, 22, und somit die Dichtheit über die Lebensdauer des Brennstoffeinspritzventils 1 sichergestellt werden.

Neben viskosen Klebstoffen können auch andere Ausgestaltungen des Dichtmittels 31' zur Anwendung kommen. Speziell kann bei geeigneter geometrischer Ausbildung der abzudichtenden Geometrie auch ein Dichtmittel 31' aus einem aufschmelzenden Klebstoff oder einem vorkonfektionierten Klebeband beziehungsweise aus vorkonfektionierten Klebebändern zum Einsatz kommen.

Die Auswahl des jeweiligen Klebstoffs ist an die Eigenschaften des abzudichtenden Mediums, die Dichtgeometrie sowie die Anforderungen des Fertigungsprozesses angepasst. Speziell kann eine Anpassung an abzudichtende Medien wie Wasser, Öl, Raps-Methylester oder andere Fettsäure-Methylester erfolgen. Ferner kann eine Anpassung der Dichtgeometrie in Bezug auf mögliche Fügerichtungen, Spalt- und Bauteiltoleranzen erfolgen. Ferner kann den Anforderungen des Fertigungsprozesses beispielsweise in Bezug auf eine vorgegebene Taktzeit entsprochen werden.

Die Erfindung ist nicht auf die beschriebenen Ausführungsbeispiele beschränkt.

## Patentansprüche

1. Piezoelektrischer Aktor (2), insbesondere Aktor für Brennstoffeinspritzventile, mit einem Aktorkörper (14), zumindest einem Übergangsstück (12) und einem Führungselement (27), wobei das Übergangsstück (12) eine Aufnahme (30), in die das Führungselement (27) zumindest teilweise eingesetzt ist, und zumindest eine Kabeldurchführung (23), die einerseits in die Aufnahme (30) mündet, aufweist, wobei zumindest eine elektrische Leitung (17) vorgesehen ist, die abschnittsweise durch das Führungselement (27), abschnittsweise durch die Kabeldurchführungen (23) und zwischen dem Führungselement (27) und der Kabeldurchführung (23) abschnittsweise durch einen Teil (31) der Aufnahme (30) des Übergangsstücks (12) geführt ist, und wobei der Teil (31) der Aufnahme (30) zumindest teilweise mit einem Dichtmittel (31') gefüllt ist.

2. Piezoelektrischer Aktor nach Anspruch 1,
**dadurch gekennzeichnet,**
**dass** der Teil (31) der Aufnahme (30), durch den die elektrische Leitung (17) zwischen dem Führungselement (27) und der Kabeldurchführung (23) des Übergangsstücks (12) geführt ist, durch das Übergangsstück (12) und das in die Aufnahme (30) des Übergangsstücks (12) eingesetzte Führungselement (27) umschlossen ist.

3. Piezoelektrischer Aktor nach Anspruch 1 oder 2,
**dadurch gekennzeichnet,**
**dass** der Teil (31) der Aufnahme (30) zumindest im Wesentlichen mit dem Dichtmittel (31') gefüllt ist.

4. Piezoelektrischer Aktor nach einem der Ansprüche 1 bis 3,
**dadurch gekennzeichnet,**
**dass** das Dichtmittel (31') auf der Basis zumindest eines Klebstoffs gebildet ist oder dass das Dichtmittel (31') auf der Basis zumindest eines Silikons gebildet ist.

5. Piezoelektrischer Aktor nach einem der Ansprüche 1 bis 3,
**dadurch gekennzeichnet,**
**dass** das Dichtmittel (31') auf der Basis zumindest eines Fetts, insbesondere eines Anti-Kapillar-Fetts, gebildet ist.

6. Piezoelektrischer Aktor nach einem der Ansprüche 1 bis 5,
**dadurch gekennzeichnet,**
**dass** das Dichtmittel (31') als ausgehärtete Dichtmasse ausgebildet ist.

7. Piezoelektrischer Aktor nach einem der Ansprüche 1 bis 3,
**dadurch gekennzeichnet,**
**dass** das Dichtmittel (31') aus zumindest einem Klebstoffband ausgebildet ist und/oder dass das Dichtmittel (31') aus zumindest einem aufschmelzenden Klebstoff gebildet ist.

8. Piezoelektrischer Aktor nach einem der Ansprüche 1 bis 7,
**dadurch gekennzeichnet,**
**dass** zumindest eine weitere elektrische Leitung (18) vorgesehen ist, die abschnittsweise durch das Führungselement (27) und abschnittsweise durch eine weitere Kabeldurchführung (24) des Übergangsstücks (12) geführt ist, und dass die weitere elektrische Leitung (18) zwischen dem Führungselement (27) und der weiteren Kabeldurchführung (24) neben der elektrischen Leitung (17) durch den mit dem Dichtmittel (31') gefüllten Teil (31) der Aufnahme (30) des Übergangsstücks (12) geführt ist.

9. Piezoelektrischer Aktor nach einem der Ansprüche 1 bis 8,
**dadurch gekennzeichnet,**
**dass** das Übergangsstück (12) an den Aktorkörper (14) gefügt ist, dass die Kabeldurchführung (24) andererseits in einen Innenraum (33) einer Dichthülse (20) mündet, dass in dem Innenraum (33) der Dichthülse (20) der Aktorkörper (14) mit zumindest einer Außenelektrode (15, 16) angeordnet ist und dass die elektrische Leitung (17) mit der Außenelektrode (15) elektrisch verbunden ist.

10. Brennstoffeinspritzventil (1), insbesondere Injektor für Brennstoffeinspritzanlagen von luftverdichtenden, selbstzündenden Brennkraftmaschinen, mit einem piezoelektischen Aktor (2) nach einem der Ansprüche 1 bis 9 und einem von dem Aktor (2) betätigbaren Ventilschließkörper (9), der mit einer Ventilsitzfläche (7) zu einem Dichtsitz zusammenwirkt.
